# EUROPEAN PATENT SPECIFICATION

(11) **EP 1 279 469 B1**
(45) Date of publication and mention of the grant of the patent: **08.11.2006**
(21) Application number: 01830482.4
(22) Date of filing: 19.07.2001
(51) Int. Cl.: B25J 15/06, B25B 11/00, B65G 47/91

(54) **Vacuum gripper to be used for the manufacture of multi-layered printed circuits**
Sauggreifer für Verwendung in der Herstellung von mehrschichtigen Leiterplatten
Préhenseur à dépression utilisable dans la fabrication de circuits imprimés multicouches

(43) Date of publication of application: 29.01.2003
(73) Proprietor: TAPEMATIC S.p.A., 20060 Ornago (MI) (IT)
(72) Inventor: Perego, Luciano, 20050 Mezzago (MI) (IT)
(74) Representative: Tansini, Elio Fabrizio

(56) References cited:
- US-A- 4 185 814
- US-A- 5 032 426
- US-A- 5 713 563

## Description

The present invention relates to a grip member for apparatus designed to make layers and multi-layered cards for printed circuits, of the type comprising the features set forth in the preamble of claim 1.

The present invention addresses to the electronic sector and in particular to the production of printed circuits normally used in computers, telephones or electronic apparatus of various kinds.

It is known that two or more types of conductive layers, usually referred to as "inner layers", on which the respective conductive paths are disposed, must be superposed and joined to form a finished card. An insulating film, called "pre-peg" and also performing the function of bonding agent or glue is interposed between a conductive layer and the next one.

For the purpose, automatic apparatus are used, of the type disclosed in document DE19628163 for example, that are able to individually pick up the conductive layers and insulating films and lay them down in an alternate sequence in an assembling station for alignment and subsequent junction of same.

The conductive and insulating layers are piled up in adjacent containers, one type for each container, to enable them to be reached and picked up by appropriate grip members.

Independent grip members running on appropriate rails, usually one for the conductive layers and one for the insulating layers, carry the layers from the storing regions to the assembling station.

Such grip members, to which the invention is particularly directed, normally have a plate-like configuration and are provided with a flat surface pierced with holes communicating with a cavity under vacuum.

The layer moved close to the surface is sucked up and held fast thereon.

Grip members in the form of a sucking plate are known which substantially have the same sizes as those of the cards to be made.

They are provided with at least two openings, passing through the plate and through which appropriate cameras can frame optical references photoengraved on the individual layers, for alignment of two superposed layers.

Such openings have slightly larger sizes than the camera lenses and are formed at positions corresponding to said optical references. Such a type of grip member is described in document US 5,048,178.

The Applicant has found that the grip members of the above described type can be improved from different points of view, in particular in connection with their flexibility of use.

More specifically, the above mentioned grip members enable management of layers and cards of one format only. In addition, the optical references on each layer must be always positioned at the same points.

Therefore, in order to enable production of cards of different shapes with the same machine, the grip members must be dismantled and replaced, which involves a prolonged stopping of the machine.

Accordingly, the present invention aims at accomplishing a grip members for layers and multi-layered cards for printed circuits capable of solving the above mentioned problems.

In particular, it is an object of the present invention to provide a grip member adapted to manage layers and finished cards of different formats.

It is a further object of the invention to provide a grip member enabling layers of different formats and having optical references disposed at different points to be aligned and joined together.

The foregoing and further objects that will become more apparent during the following description are achieved by a grip member for apparatus adapted to make layers and multi-layered cards for printed circuits, comprising the features set forth in claim 1.

Further features and the advantages of the invention will be best understood from the detailed description of a preferred but not exclusive embodiment of a grip member for apparatus adapted to make layers and multi-layered cards for printed circuits in accordance with the present invention. This description will be taken hereinafter with reference to the accompanying drawings, given by way of non-limiting example, in which:

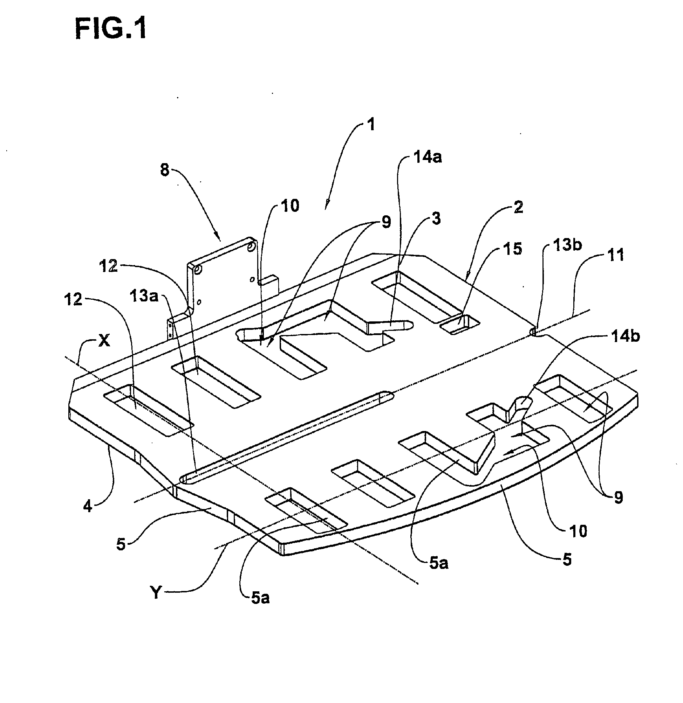

- Fig. 1 is a perspective view of a grip member for apparatus adapted to make layers and multi-layered cards for printed circuits embodied by the present invention;
- Fig. 2 is a bottom plan view of the grip member in Fig. 1;
- Fig. 3 is a section taken along line III-III in Fig. 2.

With reference to the drawings, a grip member for apparatus adapted to make layers and multi-layered cards for printed circuits in accordance with the present invention has been generally identified by reference numeral 1.

In particular, the grip member of the present invention is used in assembling apparatus for multi-layered cards starting from individual layers. Such apparatus usually comprise one or more storing stations, each equipped with a plurality of drawers in which the layers are stored, and an assembling station comprising operating elements such as optical detectors and welders designed to superpose and align said layers and join them together.

The apparatus has appropriate actuating devices capable of moving each grip member 1 between the storing stations and the assembling station to pick up the layers from the storing station and transfer them to the assembling station and to pick up the finished cards from the assembling station and take them to the storing region.

In addition, in the assembling station each grip member 1 firmly holds each individual layer to be joined to the card, while alignment and welding of same to the already assembled layers is taking place.

The grip member 1 comprises a sucking plate 2 having an upper wall 3, a lower wall 4 facing the upper wall 3 at a close distance therefrom and at least one union side wall 5 peripherally extending between the upper 3 and lower 4 walls.

The grip member 1 is fastened to the actuating devices by means of a hooking element 8 that in the preferred embodiment herein shown consists of a plate secured to one side of the sucking plate 2 in a transverse direction.

Said walls 3, 4, 5 bound a chamber 6 contained in the sucking plate 2.

Since the cards to be assembled usually have a rectangular shape, the sucking plate 2 too substantially is of same shape.

The lower wall 4 is further provided with a plurality of holes 7 bringing the chamber into communication with the surrounding atmosphere.

Appropriate sucking means, known and therefore not shown, can be connected to the chamber, by appropriate devices for support and movement of the plate for example, and said means creates a vacuum in chamber 6 sucking the air through the free holes 7 of the plate 2 itself. Therefore, the lower wall 4 moved close to one layer or one finished card, adheres thereto holding them against its surface.

The card or layer remain steadily in place by effect of the pressure difference between the free face of the card and the opposite face close to the perforated wall.

Advantageously, the vacuum in chamber 6 is of such a degree that, although many holes 7 are uncovered in the case of layers or cards of smaller sizes that those of the lower wall 4, said layers or cards are at all events safely held.

Advantageously, the upper 3 and lower 4 walls have a plurality of passages 9 through the sucking plate 2 distributed along two mutually orthogonal directions, X, Y. Passages 9 enable access of operating elements, such as optical detectors, welders, abutment members, associated with the card-manufacturing apparatus and arranged to act on work regions dedicated thereto and disposed at the peripheral edges of the individual layers.

Preferably, passages 9 are disposed parallel to two sides of the sucking plate 2 to enable access of the operating elements to the work regions dedicated thereto on layers and/or cards of different sizes and shapes.

Advantageously, said passages 9 are defined by a plurality of openings 10, facing each other two by two and formed in the upper 3 and lower 4 walls. In addition, passages 9 are bounded by lateral sealing walls 5a placed between the upper wall 3 and lower wall 4 at the edges of the openings 10, to close chamber 6 and enable the vacuum to be maintained.

Therefore, by the grip member 1 big or small layers and cards can be held fast, in such a manner that appropriate aligning references and welding points for the layers should stay close to passages 9 so that they can be respectively framed by the optical detectors and reached by the welders disposed over the sucking plate 2.

In accordance with the embodiment shown, arrangement of passages 9 is symmetric with respect to a symmetry axis 11 parallel to a side of the sucking plate 2 and placed close to the centre line of said plate 2, being also provided that each layer and/or card should be held fast by plate 2 with its median axis coincident with the symmetry axis 11 of the plate itself, for the purposes to be clarified in the following.

Advantageously, openings 10 are differentiated depending on the function they must perform.

Preferably, they comprise a series of first openings 12, dedicated to the passage of welders, symmetrically formed along two mutually opposite sides of the sucking plate 2. Each opening of the first series 12 is of elongated rectangular shape in a direction perpendicular to the symmetry axis 11.

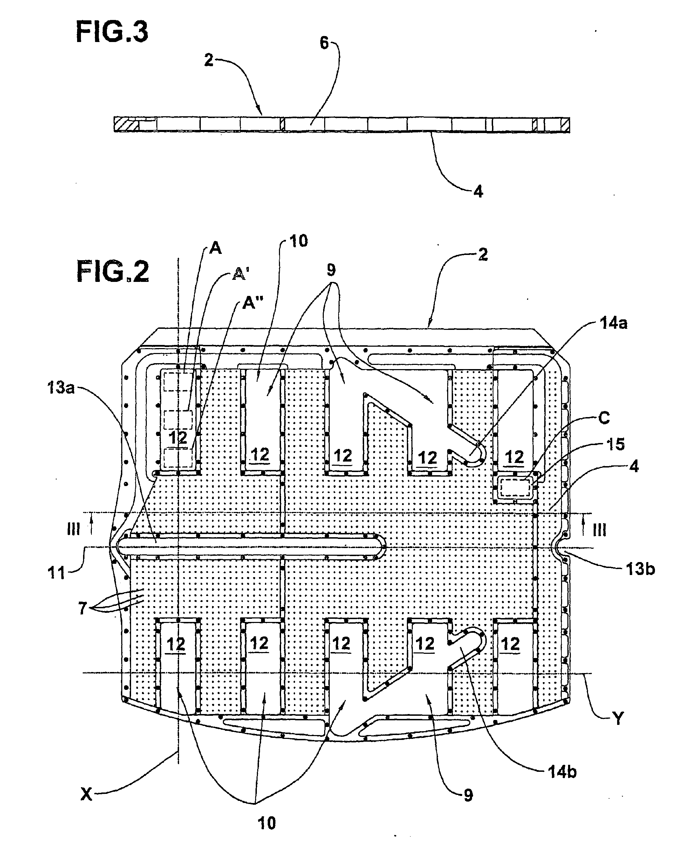

Each first opening 12 is adapted to receive a single welder that can be positioned along the opening itself, perpendicularly of the symmetry axis 11, to reach the welding regions of layers and/or cards of different formats. For better understanding the above, in Fig. 2 three different positions that can be occupied by one of the welders in one of the first openings 12 associated therewith have been identified in chain lines and denoted by A, A' and A".

In addition, a series of second openings 13 enables framing of the optical references placed on the layers to be aligned.

It is advantageous for the layers and/or cards to have their alignment references disposed on their respective median axis.

This arrangement enables possible misalignments due to the accuracy levels of the instruments intended for this purpose to be minimized.

In fact, a mistake in the alignment between two straight lines respectively belonging to two superposed layers and passing through the respective centring points results in a mistake on the remaining points of the layers, which mistake becomes bigger as the distance from said straight lines increases. If the considered straight lines are median straight lines, the maximum distance corresponds to half the width of each layer, whereas if said straight lines should be placed close to the edges, the distance would correspond to the whole width of each layer and consequently the mistake would be doubled.

Therefore, the openings of said second series 13 are preferably placed on the symmetry axis 11 and each layer is picked up by the sucking plate 2 in such a manner that its median axis will be coincident with the symmetry axis of the plate itself.

In this way, in addition, it is not necessary for the optical detectors to move from the plate axis 11 along direction "X" to adapt themselves to the varying sizes of the layers, and consequently further errors due to the tolerances of complicated actuating systems are avoided.

In the embodiment shown there are two openings 13 belonging to the second series: a first opening 13a is of elongated form and a second opening 13b is defined by a recess in the form of an arc of a circle formed in the minor side of the sucking plate 2.

A fixed optical detector works through the second opening 13b in the form of an arc of a circle while a movable optical detector moving along the symmetry axis 11 sights the optical references through the first opening 13a and can be selectively positioned depending on the sizes of the layer held fast by plate 2. For clarification purposes, three different positions that can be taken by the optical detector relative to the opening 13a of elongated shape are shown in Fig. 3 and denoted by B, B' and B".

Finally, a series of third openings 14 enables engagement of appropriate abutment elements mounted on the layer-containing drawers, when the grip member 1 picks up the layers from the drawers themselves, without said abutment elements interfering with plate 2.

As shown in the accompanying drawings, advantageously two third openings 14 are provided and identified by 14a and 14b respectively. The third openings 14a, 14b are of elongated shape and are placed sideways of the symmetry axis 11 and symmetrically converge relative to the axis itself.

The elongated shape of said third openings 14 aims at ensuring passage of the abutment elements placed at different positions in the drawers in order to block stacked layers and/or cards of different formats.

As can be easily viewed from the accompanying figures, the first and third openings 12, 13 have some regions in common with each other. In particular, each of the two third openings 14a, 14b forms a single cavity of an uneven shape together with two of the first openings 12.

The present invention achieves the intended purposes.

In fact, the grip member in accordance with the present invention allows access of the necessary tools to the respective work regions on layers of different shapes and sizes.

In particular, the grip member in accordance with the present invention enables layers and cards of different formats and/or provided with alignment references and welding regions positioned at variable points to be picked up, held fast and processed.

In fact, the openings present in the plate associated with the mobility of the operating elements enable all operations required for the manufacture of multi-layered cards to be always carried out, irrespective of the sizes of the layers and the work regions of same.

## Claims

1. A grip member for apparatus adapted to make layers and multi-layered cards for printed circuits, comprising:
- a sucking plate (2) having an upper wall (3), a lower wall (4) and at least one side wall (5);
the side wall (5) defining, in association with the upper wall (3) and lower wall (4), a chamber (6) at the inside of said sucking plate (2) which is suitable to be connected with suction means to create the vacuum in the chamber (6); the lower wall (4) further having a plurality of holes (7) for communication between said chamber (6) and the surrounding atmosphere;
**characterized in that** the upper (3) and lower (4) walls have a plurality of passages (9) through the sucking plate (2) distributed at least along two mutually orthogonal directions (X, Y).

2. A grip member as claimed in claim 1, **characterized in that** the passages (9) are defined by a plurality of openings (10) formed in the upper (3) and lower (4) walls and bounded by lateral sealing walls (5a); the lateral sealing walls (5a) being placed between the upper (3) and lower (4) walls and at the edges of said openings (10).

3. A grip member as claimed in claim 2, **characterized in that** it comprises two series of passages (9) symmetrically disposed relative to a common symmetry axis (11).

4. A grip member as claimed in claim 3, **characterized in that** the plurality of openings (10) comprises first openings (12) placed along two mutually opposite sides of the sucking plate (2) and each exhibiting an elongated conformation in a direction perpendicular to the symmetry axis (11).

5. A grip member as claimed in claim 3, **characterized in that** the plurality of openings (10) comprises second openings (13) placed on the symmetry axis (11).

6. A grip member as claimed in claim 3, **characterized in that** the plurality of openings (10) comprises third openings (14) having an elongated shape and symmetrically converging relative to said symmetry axis (11).

## Patentansprüche

1. Sauggreifer für Geräte zur Herstellung von Schichten und mehrschichtigen Karten von Leiterplatten, umfassend:
eine Saugplatte (2) mit einer oberen Wand (3), einer unteren Wand (4) und mindestens einer Seitenwand (5);
wobei die Seitenwand (5) zusammen mit der oberen Wand (3) und der unteren Wand (4) eine zur Saugplatte (2) innere Kammer (6) festlegt und mit Saugmitteln verbindbar ist, um in der Kammer (6) einen Unterdruck zu erzeugen; wobei die untere Wand (4) überdies eine Vielzahl von Verbindungsbohrungen (7) zwischen der Kammer (6) und außen aufweist;
**dadurch gekennzeichnet, dass** die obere (3) und untere Wand (4) eine Vielzahl von Durchgängen (9) durch die Saugplatte (2) aufweisen, die mindestens längs zwei zueinander senkrechten Richtungen (X, Y) verteilt sind.

2. Sauggreifer nach Anspruch 1, **dadurch gekennzeichnet, dass** die Durchgänge (9) durch eine Vielzahl von Öffnungen (10) festgelegt sind, die in der oberen (3) und unteren (4) Wand ausgenommen und durch seitliche abgedichtete Wände (5a) begrenzt sind; wobei die seitlichen abgedichteten Wände (5a) zwischen der oberen Wand (3) und der unteren Wand (4) und im Bereich der Ränder der Öffnungen (10) angeordnet sind.

3. Sauggreifer nach Anspruch 2, **dadurch gekennzeichnet, dass** er zwei Reihen von Durchgängen (9) umfasst, die gegenüber der gemeinsamen Symmetrieachse (11) symmetrisch angeordnet sind.

4. Sauggreifer nach Anspruch 3, **dadurch gekennzeichnet, dass** die Vielzahl von Öffnungen (10) erste Öffnungen (12) umfasst, die längs zwei zueinander abgewandten Seiten der Saugplatte (2) angeordnet sind und jeweils eine längliche, zur Symmetrieachse (11) senkrechte Ausbildung aufweisen.

5. Sauggreifer nach Anspruch 3, **dadurch gekennzeichnet, dass** die Vielzahl von Öffnungen (10) zweite Öffnungen (13) umfasst, die auf der Symmetrieachse (11) angeordnet sind.

6. Sauggreifer nach Anspruch 3, **dadurch gekennzeichnet, dass** die Vielzahl von Öffnungen (10) dritte Öffnungen (14) umfasst, die eine längliche Form aufweisen und gegenüber der Symmetrieachse (11) symmetrisch zusammenlaufen.

## Revendications

1. Préhenseur pour appareils destinés à la fabrication de couches et cartes multicouches pour circuits imprimés, comprenant:
- une plaque d'aspiration (2) ayant une paroi supérieure (3), une paroi inférieure (4) et au moins une paroi latérale (5);
- la paroi latérale (5) définissant, avec la paroi supérieure (3) et la paroi inférieure (4), une chambre (6) à l'intérieur de ladite plaque d'aspiration (2) qui est apte à être reliée à des moyens d'aspiration pour créer une dépression dans la chambre (6); la paroi inférieure (4) ayant en outre une pluralité de trous (7) pour la communication entre ladite chambre (6) et l'atmosphère environnante;
**caractérisé en ce que** les parois supérieure (3) et inférieure (4) ont une pluralité de passages (9) à travers la plaque d'aspiration (2) distribués au moins le long de deux directions réciproquement perpendiculaires (X, Y).

2. Préhenseur selon la revendication 1, **caractérisé en ce que** les passages (9) sont définis par une pluralité d'ouvertures (10) formées dans les parois supérieure (3) et inférieure (4) et délimitées par des parois latérales étanches (5a); les parois latérales étanches (5a) étant placées entre les parois supérieure (3) et inférieure (4) et aux bords desdites ouvertures (10).

3. Préhenseur selon la revendication 2, **caractérisé en ce qu'**il comporte deux séries de passages (9) disposées symétriquement par rapport à un axe commun de symétrie (11).

4. Préhenseur selon la revendication 3, **caractérisé en ce que** la pluralité d'ouvertures (10) comporte des premières ouvertures (12) placées le long de deux côtés réciproquement opposés de la plaque d'aspiration (2) et présentant chacune une conformation allongée dans une direction perpendiculaire à l'axe de symétrie (11).

5. Préhenseur selon la revendication 3, **caractérisé en ce que** la pluralité d'ouvertures (10) comporte des deuxièmes ouvertures (13) placées sur l'axe de symétrie (11).

6. Préhenseur selon la revendication 3, **caractérisé en ce que** la pluralité d'ouvertures (10) comporte des troisièmes ouvertures (14) ayant une forme allongée et convergeant symétriquement par rapport audit axe de symétrie (11).
